(19) **Europäisches Patentamt / European Patent Office / Office européen des brevets**

(11) **EP 3 717 676 B1**

(12) # EUROPÄISCHE PATENTSCHRIFT

(45) Veröffentlichungstag und Bekanntmachung des Hinweises auf die Patenterteilung:
**19.11.2025   Patentblatt 2025/47**

(21) Anmeldenummer: **18811507.5**

(22) Anmeldetag: **28.11.2018**

(51) Internationale Patentklassifikation (IPC):
**C23C 14/56** *(2006.01)*      **C23C 16/54** *(2006.01)*

(52) Gemeinsame Patentklassifikation (CPC):
**C23C 14/566; C23C 16/54**

(86) Internationale Anmeldenummer:
**PCT/EP2018/082798**

(87) Internationale Veröffentlichungsnummer:
**WO 2019/105985 (06.06.2019 Gazette 2019/23)**

(54) **VAKUUMSCHLEUSE UND VERFAHREN ZUM SCHLEUSEN EINES SUBSTRATTRÄGERS**

VACUUM LOCK AND METHOD FOR TRANSFERRING A SUBSTRATE CARRIER VIA A LOCK

SAS À VIDE ET PROCÉDÉ POUR FAIRE PASSER UN SUPPORT DE SUBSTRAT DANS UN SAS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.11.2017   DE 102017011064**

(43) Veröffentlichungstag der Anmeldung:
**07.10.2020   Patentblatt 2020/41**

(73) Patentinhaber: **Singulus Technologies AG**
**63796 Kahl am Main (DE)**

(72) Erfinder:
- **CORD, Bernhard**
  **63755 Alzenau (DE)**
- **REISING, Michael**
  **63776 Mömbris (DE)**
- **SCHERGER, Dieter**
  **63868 Großwallstadt (DE)**

(74) Vertreter: **Vossius & Partner**
**Patentanwälte Rechtsanwälte mbB**
**Siebertstrasse 3**
**81675 München (DE)**

(56) Entgegenhaltungen:
**DE-A1- 102015 117 753**

**Beschreibung**

Die Erfindung betrifft Vorrichtungen und Verfahren zum Einschleusen und/oder Ausschleusen von Substraten in eine Prozessstrecke. Die Erfindung betrifft insbesondere eine Vakuumschleuse für eine Vakuumbeschichtungsanlage und ein Verfahren zum Einschleusen eines Substratträgers aus einer Umgebung unter Normaldruck in eine Vakuumbeschichtungsanlage und/oder zum Ausschleusen des Substratträgers aus der Vakuumbeschichtungsanlage in eine Umgebung unter Normaldruck.

Für eine Vakuumbeschichtung müssen die zu beschichtenden Substrate über eine Vakuumschleuse, deren Gasdruck typischerweise zwischen Normaldruck und einem deutlich kleineren Druck, beispielsweise einem Druck von weniger als 100 Pa, verändert wird, in eine Prozessstrecke eingebracht werden. Für einen hohen Anlagendurchsatz ist eine kurze Taktzeit und somit ein rasches Evakuieren und Fluten der Vakuumschleuse wünschenswert.

Insbesondere bei kleinen und leichten Substraten besteht das Risiko, dass durch eine starke Gasbewegung während des Evakuierens oder Flutens die Substrate von ihrem Ablageplatz oder ihrer Position auf einem Substratträger angehoben oder sogar beschädigt werden. Das Risiko einer unerwünschten Bewegung oder Beschädigung der Substrate kann verringert werden, indem die zeitliche Druckänderung der Vakuumschleuse beim Evakuieren und Fluten klein gehalten wird. Dies erhöht jedoch die für das Ein- und Ausschleusen benötigte Zeit in unerwünschter Weise. Die Verwendung mehrerer Vakuumschleusen, über die beispielsweise alternierend Substrate eingeschleust werden, wie sie beispielsweise in der WO 2016/173125 A1 beschrieben ist, kann die Taktzeit effektiv erhöhen, erfordert jedoch die Bereitstellung zusätzlicher Vakuumschleusen und/oder komplexerer Vakuumschleusenanordnungen.

Die DE 10 2012 109 830 A1 offenbart eine Schleusenkammer für eine horizontale Durchlaufanlage.

Die DE 10 2011 011 279 A1 offenbart eine Apparatur zur Leitung eines Gasstromes beim Belüften innerhalb eines Vakuumgehäuses.

Die DE 10 2005 024 181 A1 offenbart eine Transportanlage für eine Vakuumkammer.

Die DE 10 2015 117753 A1 offenbart eine Vakuumschleuse mit Evakuieren eines Substratträgers in entgegengesetzte Richtungen, so dass Gasströmungen auf der Ober- und Unterseite des Substratträgers jeweils halbiert werden.

Um ein Herausdrücken von Substraten aus den jeweiligen Aufnahmen im Substratträger zu verhindern, können Haltevorrichtungen vorgesehen werden. Dies führt zu erhöhtem Aufwand beim Laden und Entladen des Substratträgers. Außerdem besteht weiterhin das Risiko einer Beschädigung der Substrate.

Es besteht ein Bedarf an verbesserten Vorrichtungen und Verfahren zum Einschleusen und/oder Ausschleusen von Substraten in eine Prozessstrecke. Es besteht insbesondere ein Bedarf an derartigen Vorrichtungen und Verfahren, die für die Überwindung von Druckunterschieden in einem Prozess oder einer Anlage, beispielsweise zur Vakuumbeschichtung, geeignet sind. Es besteht insbesondere ein Bedarf an derartigen Vorrichtungen und Verfahren, die das Risiko verringern, dass ein Substrat beim Schleusen unerwünscht an oder in dem Substratträger verschoben oder beschädigt wird, wobei kurze Taktzeiten erzielbar sind. Es besteht insbesondere ein Bedarf an derartigen Vorrichtungen und Verfahren, die das Risiko verringern, dass ein Substrat beim Schleusen unerwünscht an oder in dem Substratträger verschoben oder beschädigt wird, ohne dass hierfür die Bereitstellung mehrerer parallel arbeitender Vakuumschleusen zum Einschleusen in dieselbe Prozesslinie und/oder die Verwendung von Halteelementen, die die Substrate an dem Substratträger halten, nötig sind.

Erfindungsgemäß werden Vakuumschleusen und Verfahren mit den in den unabhängigen Ansprüchen angegebenen Merkmalen bereitgestellt. Die abhängigen Ansprüche definieren Ausführungsformen.

Nach einem Aspekt der Erfindung wird eine Vakuumschleuse für eine Vakuumbeschichtungsanlage nach Anspruch 1 bereitgestellt.

Wenn die Kammer über zwei Seiten evakuiert und/oder geflutet wird, ist vorteilhaft das Verhältnis des ersten Abstands $d_1$ zur Hälfte der Substratträgerlänge L kleiner als 0,1, bevorzugt kleiner als 0,05, also $d_1/(L/2) < 0,1$, bevorzugt $d_1)/(L/2) < 0,05$, und das Verhältnis des zweiten Abstands $d_2$ zur Hälfte der Substratträgerlänge L ist vorteilhaft kleiner als 0,1, bevorzugt kleiner als 0,05, also $d_2/(L/2) < 0,1$, bevorzugt $d_2/(L/2) < 0,05$.

Die Vakuumschleuse kann so konfiguriert sein, dass ein Verhältnis eines ersten Strömungswiderstands zwischen dem Substratträger und der ersten Innenoberfläche zu einem zweiten Strömungswiderstand zwischen dem Substratträger und der zweiten Innenoberfläche zwischen 0,95 und 1,05 liegt.

Die Vakuumschleuse kann derart ausgestaltet sein, dass das Verhältnis des ersten Strömungswiderstands zu dem zweiten Strömungswiderstand zwischen 0,97 und 1,03 liegt.

Die Vakuumschleuse kann derart ausgestaltet sein, dass ein Druckunterschied zwischen der ersten Substratträgeroberfläche und der zweiten Substratträgeroberfläche maximal 10 Pa, bevorzugt maximal 5 Pa, weiter bevorzugt maximal 4 Pa beträgt, selbst wenn bei einem Evakuieren oder Fluten der Kammer eine Druckänderungsrate in der Kammer von wenigstens 100 hPa/s, bevorzugt von wenigstens 300 hPa/s, insbesondere von 300 hPa/s bis 500 hPa/s erreicht wird.

Die Vakuumschleuse kann derart konfiguriert sein, dass ein Druckunterschied zwischen der ersten Substratträgeroberfläche und der zweiten Substratträgeroberfläche maximal 10 Pa , bevorzugt maximal 5 Pa, weiter bevorzugt maximal 4 Pa beträgt, selbst wenn bei einem Abpumpvorgang oder Flutvorgang der Kammer eine Druckänderungsrate von wenigstens100 hPa/s, bevorzugt von wenigstens 300 hPa/s, insbesondere von 300 hPa/s bis 500 hPa/s erreicht wird .

Die erfindungsgemäßen Vakuumschleusen verringern das Risiko, dass Substrate unbeabsichtigt von dem Substratträger abgehoben und/oder beschädigt werden, wenn die Kammer der Vakuumschleuse evakuiert oder geflutet wird. Dies gilt bei einem Kammervolumen von wenigstens100 1, bevorzugt von 200 bis 500 1 selbst bei relativ hohen Druckänderungsraten in der Kammer, die beispielsweise 100 hPa/s oder sogar 300 hPa/s übersteigen, beispielsweise zwischen 300 hPa/s und 500 hPa/s liegen, und/oder wenn die Flutzeit 10 s unterschreitet.

Der Substratträger kann so ausgestaltet sein, dass die Substrate im Wesentlichen formschlüssig in den Öffnungen auf einem Substratträger liegen, so dass ein Gasdurchtritt durch den Substratträger mit darauf positionierten Substraten stark eingeschränkt wird.

Die Fördereinrichtung kann konfiguriert sein, den Substratträger zwischen der ersten Innenoberfläche und der zweiten Innenoberfläche der Kammer derart zu positionieren, dass $|d_1 - d_2|/max(d_1, d_2)$ weniger als 15%, bevorzugt weniger als 8%, beträgt. Dabei bezeichnet $d_1$ einen ersten Abstands zwischen der ersten Substratträgeroberfläche und der ersten Innenoberfläche. Der Abstand $d_2$ bezeichnet einen zweiten Abstand zwischen der zweiten Substratträgeroberfläche und der zweiten Innenoberfläche.

Die Strömungskanalanordnung kann wenigstens einen Kanal aufweisen und kann konfiguriert sein, beim Fluten und/oder Evakuieren der Kammer eine senkrecht zu einer Längsrichtung des Kanals gerichtete Gasströmung an wenigstens einem Bereich der ersten Substratträgeroberfläche und wenigstens einem Bereich der zweiten Substratträgeroberfläche zu erzeugen und Querströmungen parallel zur Längsrichtung des Kanals zu unterbinden.

Die Längsrichtung des Kanals kann parallel zu einer Längsseite des Substratträgers sein, wobei der Kanal entlang einer Längsseite der Kammer angeordnet ist. Die Längsrichtung des Kanals kann sich senkrecht zur Längsseite des Substratträgers erstrecken, wobei der Kanal entlang einer Stirnseite der Kammer angeordnet ist.

Die Strömungskanalanordnung weist wenigstens einen weiteren Kanal auf, der sich parallel zu dem wenigstens einen Kanal erstrecken kann.

Der wenigstens eine weitere Kanal kann von dem wenigstens einen Kanal um mindestens die Länge des Substratträgers entlang einer Fahrtrichtung der Fördereinrichtung beabstandet sein.

Der wenigstens eine Kanal und der wenigstens eine weitere Kanal sind an entgegengesetzten Seiten der Kammer angeordnet.

Der wenigstens eine Kanal und der wenigstens eine weitere Kanal können symmetrisch, insbesondere in Bezug auf eine Mittelebene der Kammer spiegelsymmetrisch zueinander angeordnet sein.

Die Vakuumschleuse kann zueinander symmetrisch ausgestaltete Fluidverbindungsleitungen zwischen der Evakuierungseinrichtung und entgegengesetzten Seiten der Kammer aufweisen. Die Fluidverbindungsleitungen können die entgegengesetzten Seiten der Vakuumschleuse mit einer gemeinsamen Evakuierungseinrichtung verbinden. Die entgegengesetzten Seiten können dabei Längsseiten oder Stirnseiten der Kammer sein.

Alternativ oder zusätzlich kann die Vakuumschleuse zueinander symmetrisch ausgestalteten Fluidverbindungsleitungen zwischen der Fluteinrichtung und entgegengesetzten Seiten der Kammer aufweisen. Die Fluidverbindungsleitungen können die entgegengesetzten Seiten der Kammer mit einer Fluteinrichtung verbinden. Die entgegengesetzten Seiten können dabei Längsseiten oder Stirnseiten der Kammer sein.

Die Vakuumschleuse ist derart konfiguriert, dass die Kammer über den wenigstens einen Kanal und den wenigstens einen weiteren Kanal evakuiert wird und dass die Kammer über den wenigstens einen Kanal und den wenigstens einen weiteren Kanal geflutet wird. Dadurch können gleichmäßige Strömungsfelder erzeugt und das Risiko verringert werden, dass beim Evakuieren und/oder Fluten unerwünscht hohe Druckdifferenzen zwischen erster und zweiter Substratträgeroberfläche auftreten, die zu einem Abheben oder einer Beschädigung der Substrate führen können. Durch das gleichzeitige Evakuieren der Kammer, an den zwei gegenüberliegenden Seiten des Substratträgers, teilt sich der Strom zwischen den Substratträgeroberflächen und den ihnen gegenüberliegenden Kammerinnenoberflächen auf die beiden am Rand des Substratträgers angeordneten Evakuierungskanäle auf. Dadurch wird für wenigstens einen Teil der Substrate eine Halbierung des über die Substrate streichenden maximalen Gasvolumens erzielt. Dies gilt entsprechend beim Fluten der Kammer.

Der wenigstens eine Kanal ist in einen ersten Kanal und einen zweiten Kanal unterteilt, die durch wenigstens eine Überströmöffnung in einer Fluidverbindung stehen. Der erste Kanal und der zweite Kanal können so angeordnet sein, dass der erste Kanal geometrisch über dem zweiten Kanal angeordnet ist.

Die Vakuumschleuse kann eine Einrichtung zur Vergleichmäßigung der Strömung zwischen dem ersten Kanal und dem zweiten Kanal aufweisen. Die Einrichtung zur Vergleichmäßigung der Strömung kann die wenigstens eine Überströmöffnung aufweisen. Eine Fläche der Überstromöffnung kann kleiner als ein Querschnitt des zweiten Strömungskanales sein.

Der wenigstens eine Kanal kann konfiguriert sein, beim Fluten und/oder Evakuieren der Kammer die Gasströmung derart zu erzeugen, dass an der ersten Substratträgeroberfläche und der zweiten Substratträgeroberfläche ein Druckgradient in einer Richtung parallel zur Längsrichtung des wenigstens einen Kanals minimiert wird. Dadurch können gleichmäßige Strömungsfelder erzeugt und das Risiko verringert werden, dass beim Evakuieren und/oder Fluten unerwünscht hohe Druckdifferenzen auftreten, die zu einem Abheben oder einer Beschädigung der Substrate führen können.

Die Fördereinrichtung kann konfiguriert sein, den Substratträger entlang einer Fahrtrichtung zu bewegen. Der wenigstens eine Kanal kann sich senkrecht zur Fahrtrichtung erstrecken. Der wenigstens eine Kanal kann sich parallel zur Fahrtrichtung erstrecken.

Die Fördereinrichtung kann konfiguriert sein, den Substratträger beim Fluten und Evakuieren der Kammer nicht-überlappend mit dem wenigstens einen Kanal zu positionieren.

Der wenigstens eine Kanal kann eine Öffnung für eine Fluidverbindung des wenigstens einen Kanals mit einer Fluteinrichtung und/oder einer Evakuierungseinrichtung aufweisen.

An der Überströmöffnung zwischen dem ersten Kanal und dem zweiten Kanal oder an der Öffnung für die Fluidverbindung des wenigstens einen Kanals mit der Fluteinrichtung und/oder der Evakuierungseinrichtung kann ein Gasprallblech zur Ablenkung des Gasstromes gegen eine Wand der Kammer angeordnet sein.

Die Vakuumschleuse kann wenigstens einen Anschlussstutzen zur Verbindung mit einer Evakuierungseinrichtung und/oder einer Fluteinrichtung aufweisen.

Die Vakuumschleuse kann wenigstens eine Ventilanordnung, die zwischen der Kammer und der Evakuierungseinrichtung und/oder Fluteinrichtung vorgesehen ist, aufweisen.

Die Ventilanordnung kann ein erstes Ventil und ein zweites Ventil, die unterschiedlich dimensioniert sind, aufweisen.

Die Vakuumschleuse kann eine Steuerung zum Ansteuern des ersten Ventils und des zweiten Ventils für ein zweistufiges Fluten und/oder ein zweistufiges Evakuieren der Kammer aufweisen. Die Steuerung kann konfiguriert sein, zeitabhängig das erste Ventil und das zweite Ventil so anzusteuern, dass ein Betrag der Druckänderungsrate im Inneren der Kammer während des Flutens und/oder Evakuierens einstellbar ist.

Eine Vakuumbeschichtungsanlage zum Beschichten mehrerer Substrate nach einem Ausführungsbeispiel weist die Vakuumschleuse nach einem Aspekt oder Ausführungsbeispiel auf.

Die Vakuumbeschichtungsanlage kann eine Anlage zur physikalischen Dampfabscheidung (PVD, "physical vapour deposition"), chemischen Gasphasenabscheidung (CVD, "chemical vapour deposition") oder eine Anlage zur metallorganischen chemischen Gasphasenabscheidung (MOCVD, "metalorganic chemical vapour deposition") sein, ohne hierauf beschränkt zu sein.

Nach einem weiteren Aspekt der Erfindung wird ein Verfahren zum Einschleusen eines Substratträgers in eine Vakuumbeschichtungsanlage oder zum Ausschleusen des Substratträgers aus der Vakuumbeschichtungsanlage nach Anspruch 11 angegeben.

Wenn die Kammer über zwei Seiten evakuiert und/oder geflutet wird, ist vorteilhaft das Verhältnis des ersten Abstands $d_1$ zur Hälfte der Substratträgerlänge L kleiner als 0,1, bevorzugt kleiner als 0,05, also $d_1/(L/2) < 0,1$, bevorzugt $d_1/(L/2) < 0,05$, und das Verhältnis des zweiten Abstands $d_2$ zur Hälfte der Substratträgerlänge L ist vorteilhaft kleiner als 0,1, bevorzugt kleiner als 0,05, also $d_2/(L/2) < 0,1$, bevorzugt $d_2/(L/2) < 0,05$.

Bei dem Verfahren kann ein Verhältnis eines ersten Strömungswiderstands zwischen dem Substratträger und der ersten Innenoberfläche zu einem zweiten Strömungswiderstand zwischen dem Substratträger und der zweiten Innenoberfläche zwischen 0,95 und 1,05, bevorzugt zwischen 0,97 und 1,03, liegen.

Ein Verhältnis des Betrags der Strömungsgeschwindigkeit der Gasströmung an der ersten Substratträgeroberfläche zu dem Betrag der Strömungsgeschwindigkeit der Gasströmung an der zweiten Substratträgeroberfläche kann zwischen 0,95 und 1,05, bevorzugt zwischen 0,97 und 1,03, liegen.

Ein Druckunterschied zwischen der ersten Substratträgeroberfläche und der zweiten Substratträgeroberfläche kann maximal 10 Pa , bevorzugt maximal 5 Pa, weiter bevorzugt maximal 4 Pa betragen, wenn bei einem Evakuieren oder Fluten der Kammer eine Druckänderungsrate von wenigstens100 hPa/s, bevorzugt von wenigstens 300 hPa/s, insbesondere von 300 hPa/s bis 500 hPa/s erreicht wird. Das Kammervolumen kann wenigstens100 l, bevorzugt von 200 bis 500 l, betragen.

Ein Druckunterschied zwischen der ersten Substratträgeroberfläche und der zweiten Substratträgeroberfläche kann maximal 10 Pa , bevorzugt maximal 5 Pa, weiter bevorzugt maximal 4 Pa betragen, wenn bei einem Abpumpvorgang oder Flutvorgang der Kammer eine Druckänderungsrate wenigstens100 hPa/s, bevorzugt von wenigstens 300 hPa/s, insbesondere von 300 hPa/s bis 500 hPa/s erreicht wird. Das Kammervolumen kann wenigstens100 l, bevorzugt von 200 bis 500 l, betragen.

Die erfindungsgemäßen Vakuumschleusen und Verfahren verringern das Risiko, dass Substrate unbeabsichtigt von dem Substratträger abgehoben und/oder beschädigt werden, wenn die Kammer der Vakuumschleuse evakuiert oder geflutet wird. Dies gilt selbst bei relativ hohen Druckänderungsraten in der Kammer, die beispielsweise 100 hPa/s oder sogar 300 hPa/s übersteigen und/oder wenn die Flutzeit 10 s unterschreitet bei einem typischen Kammervolumen wenigstens 100 l, bevorzugt von 200 bis 500 l.

Der Substratträger kann so ausgestaltet sein, dass die Substrate im Wesentlichen formschlüssig an dem Substratträger anliegen, so dass ein Gasdurchtritt durch den Substratträger mit daran positionierten Substraten unterbunden wird.

Der Substratträger kann zwischen einer ersten Innenoberfläche und einer zweiten Innenoberfläche der Kammer so positioniert werden, dass eine relative Differenz eines ersten Abstands zwischen der ersten Sub-

strattträgeroberfläche und der ersten Innenoberfläche und eines zweiten Abstands zwischen der ersten Substratträgeroberfläche und der ersten Innenoberfläche weniger als 15%, bevorzugt weniger als 8%, beträgt. D.h., wenn $d_1$ den ersten Abstand und $d_2$ den zweiten Abstand bezeichnet, kann der Substratträger so positioniert werden, dass $| d_1 - d_2|/max(d_1, d_2) < 15\%$, und insbesondere so, dass $| d_1 - d_2|/max(d_1, d_2) < 8\%$.

Die Kammer kann über wenigstens einen Kanal, der eine Längsrichtung aufweist, derart evakuiert und/oder geflutet werden, dass an der ersten Substratträgeroberfläche und der zweiten Substratträgeroberfläche Querströmungen parallel zur Längsrichtung des wenigstens einen Kanals unterbunden werden.

Die Längsrichtung des Kanals kann parallel zu einer Längsrichtung des Substratträgers sein, wobei der Kanal entlang einer Längsseite der Kammer angeordnet ist. Die Längsrichtung des Kanals kann parallel zu einer Querrichtung des Substratträgers sein, wobei der Kanal entlang einer Stirnseite der Kammer angeordnet ist.

Die Kammer wird gleichzeitig über wenigstens zwei an entgegengesetzten Seiten der Kammer angeordnete Kanäle evakuiert. Durch das gleichzeitige Evakuieren der Kammer über die wenigstens zwei an den entgegengesetzten Seiten der Kammer angeordneten Kanäle wird eine Verringerung des über die Substrate streichenden maximalen Gasvolumens erzielt.

Die Kammer wird gleichzeitig über die wenigstens zwei an den entgegengesetzten Seiten der Kammer angeordnete Kanäle geflutet. Durch das gleichzeitige Fluten der Kammer über die wenigstens zwei an den entgegengesetzten Seiten der Kammer angeordneten Kanäle wird eine Verringerung des über jedes Substrat streichenden Gasvolumens erzielt.

Das erfindungsgemäße Verfahren zum Schleusen kann mit der Vakuumschleuse nach einem Aspekt oder Ausführungsbeispiel ausgeführt werden.

Ein Verfahren zum Beschichten eines Substrats kann die folgenden Schritte aufweisen: Positionieren des Substrats an einem Substratträger und Einschleusen des Substratträgers in eine Vakuumbeschichtungsanlage mit dem erfindungsgemäßen Verfahren zum Einschleusen des Substratträgers.

Das Beschichtungsverfahren kann eine physikalische Dampfabscheidung (PVD, "physical vapour deposition"), eine chemische Gasphasenabscheidung (CVD, "chemical vapour deposition") oder eine metallorganische chemischen Gasphasenabscheidung (MOCVD, "metalorganic chemical vapour deposition") aufweisen, ohne darauf beschränkt zu sein.

Die erfindungsgemäßen Vakuumschleusen und Verfahren verringern das Risiko, dass ein Substrat in der Vakuumschleuse unerwünscht an dem Substratträger verschoben oder beschädigt wird. Dies wird selbst für relativ kurze Evakuierungszeiten oder Flutzeiten erreicht, bei denen die Druckänderungsrate in der Kammer beispielsweise 300 hPa/s übersteigen kann. Die erfindungsgemäßen Vakuumschleusen, Beschichtungsvorrichtungen und Verfahren sind effizient, da sie weder die Verwendung mehrerer parallel arbeitender Vakuumschleusen zum Einschleusen in dieselbe Prozesslinie noch die Arretierung der Substrate unter Verwendung von Halteelementen erfordern.

Ausführungsbeispiele der Erfindung werden nachfolgend unter Bezugnahme auf die Figuren ausführlich beschrieben, in denen identische Bezugszeichen identische oder ähnliche Elemente bezeichnen.

Figur 1 zeigt eine teilweise Perspektivansicht einer Vakuumschleuse nach einem Ausführungsbeispiel.
Figur 2 zeigt eine teilweise Schnittansicht der Vakuumschleuse.
Figur 3 zeigt eine Schnittansicht der Vakuumschleuse.
Figur 4 zeigt eine teilweise abgebrochene Perspektivansicht der Vakuumschleuse.
Figur 5 zeigt einen pneumatischen Schaltplan der Vakuumschleuse.
Figur 6 zeigt ein Strömungsfeld an einer ersten Substratträgeroberfläche beim Evakuieren einer Kammer der Vakuumschleuse.
Figur 7 zeigt ein Strömungsfeld an einer zweiten Substratträgeroberfläche beim Evakuieren einer Kammer der Vakuumschleuse.

Während bevorzugte oder vorteilhafte Ausführungsbeispiele unter Bezugnahme auf die Figuren beschrieben werden, können bei weiteren Ausführungsbeispielen zusätzliche oder alternative Ausgestaltungen realisiert werden. Während beispielsweise in den Figuren ein Substratträger für im Wesentlichen rechteckige Substrate dargestellt ist, können erfindungsgemäße Vakuumschleusen und Verfahren auch für nicht rechteckige Substrate, beispielsweise kreisförmige Substrate, eingesetzt werden. Während bei den in den Figuren dargestellten Ausführungsbeispielen die Kammer über an entgegengesetzten Stirnseiten vorgesehene Kanäle evakuiert und geflutet wird, können bei weiteren Ausführungsbeispielen die Kanäle auch an den Längsseiten der Kammer angeordnet sein. Bei weiteren Ausführungsbeispielen muss das Evakuieren und/oder Fluten der Kammer nicht zwingend gleichzeitig an zwei entgegengesetzten Seiten der Kammer erfolgen.

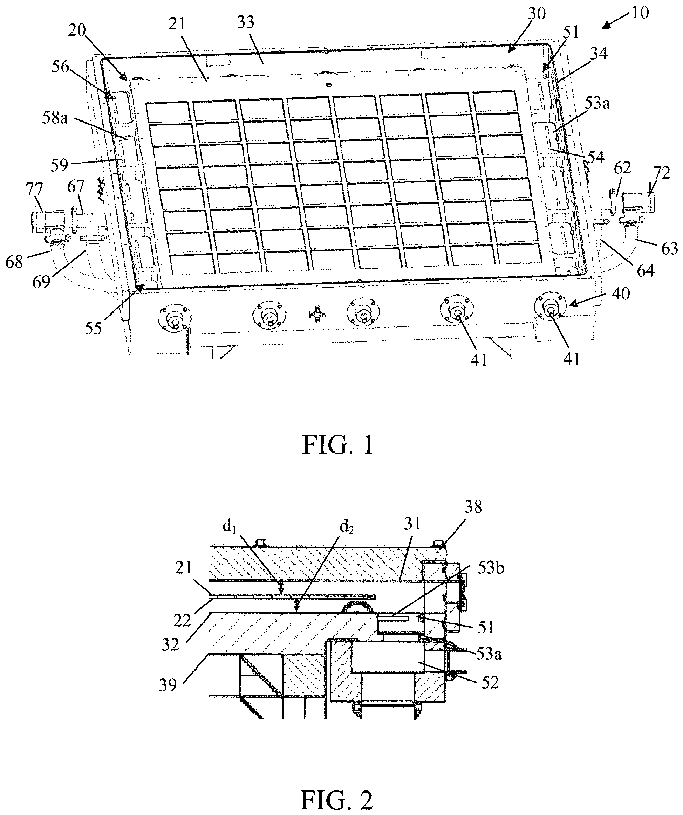

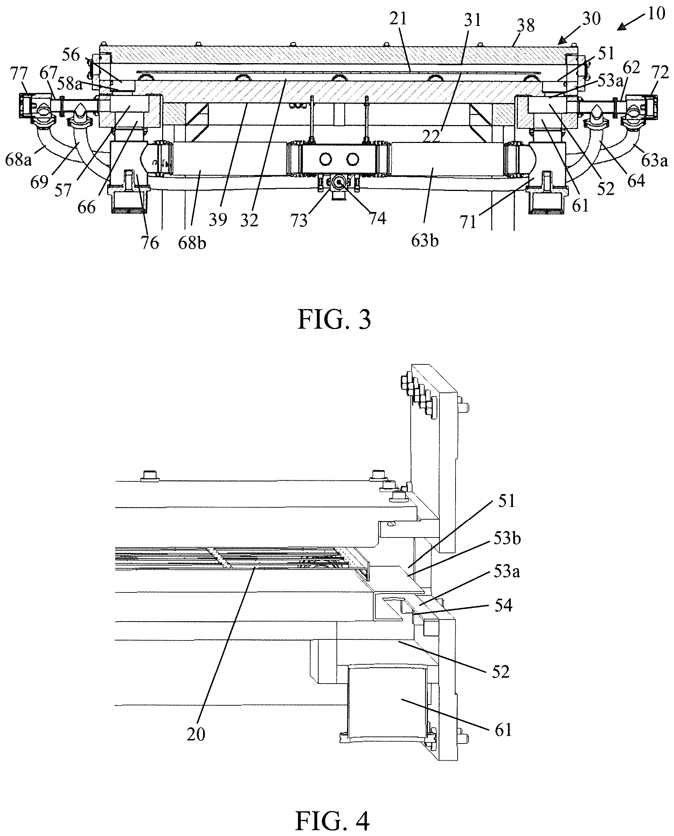

Figur 1 zeigt eine teilweise Perspektivansicht einer erfindungsgemäßen Vakuumschleuse 10, wobei ein Kammeroberteil 38 einer Kammer 30 der Vakuumschleuse 10 nicht dargestellt ist. Figur 2 zeigt eine teilweise Schnittansicht eines Endbereichs einer Kammer 30 der Vakuumschleuse 10. Figur 3 zeigt eine Schnittansicht der Kammer 30. Figur 4 zeigt eine teilweise abgebrochene Perspektivansicht der Kammer 30.

Die Kammer 30 ist zur Aufnahme eines Substratträgers 20 konfiguriert. Der Substratträger 20 weist mehrere Ablagen für Substrate auf. Dabei können die Substrate jeweils so an dem Substratträger 20 positioniert sein, dass ein Druckausgleich durch die im Sub-

strattträger 20 vorhandenen Öffnungen im Wesentlichen unterbunden wird, wenn die Substrate an oder in dem Substratträger 20 positioniert sind.

Die Kammer 30 weist ein Kammeroberteil 38 und ein Kammerunterteil 39 auf. Das Kammeroberteil 38 weist eine beim Schleusen von Substraten zum Substratträger 20 weisende erste Innenoberfläche 31 auf. Das Kammerunterteil 39 weist eine beim Schleusen von Substraten zum Substratträger 20 weisende zweite Innenoberfläche 32 auf. Die erste Innenoberfläche 31 und die zweite Innenoberfläche 32 sind im Wesentlichen eben. Der Substratträger 20 weist eine beim Schleusen von Substraten zur ersten Innenoberfläche 31 zeigende erste Substratträgeroberfläche 21 auf. Der Substratträger 20 weist eine beim Schleusen von Substraten zur zweiten Innenoberfläche 32 zeigende zweite Substratträgeroberfläche 22 auf.

Die Kammer 30 weist ein Innenvolumen auf. Das Innenvolumen der Kammer 30 kann wenigstens 100 l, bevorzugt von 200 bis 500 l, betragen.

Die Vakuumschleuse 10 weist eine Fördereinrichtung 40 auf. Die Fördereinrichtung 40 weist Antriebskomponenten 41 zum Fördern des Substratträgers auf. Die Antriebskomponenten 41 sind ausgelegt, den Substratträger 20 in einer Fahrtrichtung zu bewegen. Die Antriebskomponenten 41 können mehrere Förderwalzen sein, die entlang der Fahrtrichtung voneinander beabstandet an der Kammer 30 angeordnet sind. Der Substratträger 20 kann auf den Antriebskomponenten 41 aufliegen.

Wie in Figur 2 und Figur 3 dargestellt ist, ist die Fördereinrichtung 40 konfiguriert, den Substratträger 20 zwischen der ersten Innenoberfläche 31 und der zweiten Innenoberfläche 32 der Kammer 30 zu positionieren.

Die erfindungsgemäße Vakuumschleuse 10 ist so konfiguriert, dass statische Druckdifferenzen zwischen der ersten Substratträgeroberfläche 21 und der zweiten Substratträgeroberfläche 22 beim Fluten und/oder Evakuieren gering gehalten werden, beispielsweise kleiner als 10 Pa, bevorzugt kleiner als 5 Pa, weiter bevorzugt kleiner als 4 Pa, während die Kammer geflutet oder evakuiert wird. Hierzu können verschiedene Maßnahmen ergriffen werden:

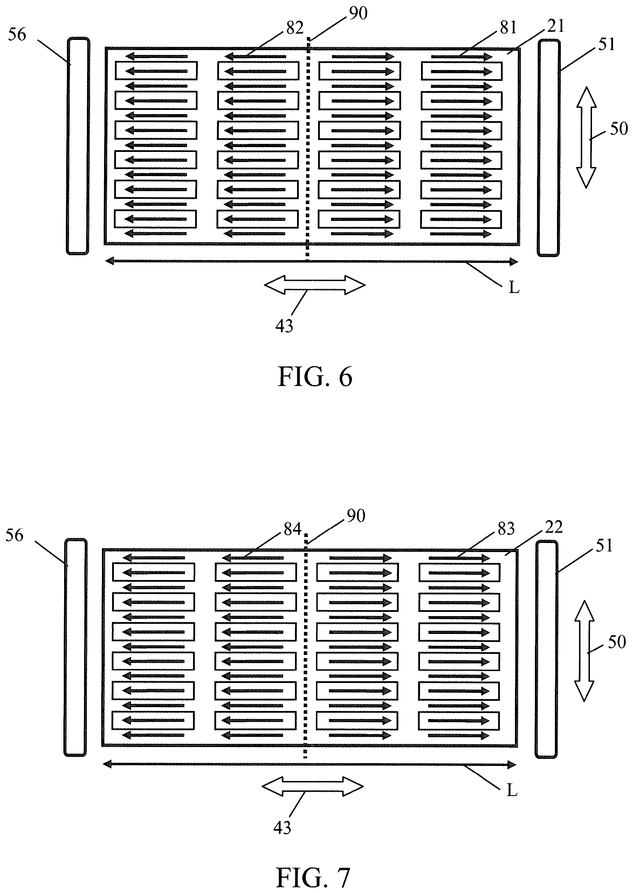

- Die Fördereinrichtung 40 kann den Substratträger 20 so positionieren, dass die Abstände der Substrate im Substratträger 20 zur ersten Innenoberfläche 31 und zur zweiten Innenoberfläche 32 der Kammer im Wesentlichen gleich sind.
- Ein Verhältnis eines Abstands zwischen einer Innenoberfläche der Kammer und der gegenüberliegenden Substratträgeroberfläche zu einer (in Figur 6 und Figur 7 dargestellten) Länge L des Substratträgers ist kleiner als 0,1, bevorzugt kleiner als 0,05, weiter bevorzugt kleiner als 0,025. Dies gilt vorteilhaft sowohl für das Verhältnis eines ersten Abstands $d_1$ zwischen der ersten Innenoberfläche 31 und der ersten Substratträgeroberfläche 21 zu der Länge L als auch für ein Verhältnis eines zweitens Abstands $d_2$ zwischen der zweiten Innenoberfläche 32 und der zweiten Substratträgeroberfläche 22 zu der Länge L des Substratträgers 20.

- In der durch die Fördereinrichtung 40 definierten Fahrtrichtung des Substratträgers 20 kann das Gas entlang der Fahrtrichtung und entgegen der Fahrtrichtung eingelassen und/oder abgepumpt werden, so dass das Gas an den beiden Hälften des Substratträgers 20 in unterschiedliche Richtungen strömt, wie in Figur 6 und Figur 7 veranschaulicht.
- Die Vakuumschleuse 10 kann eine Strömungskanalanordnung aufweisen, die konfiguriert ist, quer zur Fahrtrichtung des Substratträgers einen im Wesentlichen homogenen Gasstrom zu ermöglichen. Durch die Strömungskanalanordnung können beispielsweise diagonale Gasströmungen über die Substratträgeroberflächen 21, 22 vermieden werden.

Durch die oben genannten und optionale weitere Maßnahmen kann erreicht werden, dass an zwei voneinander vertikal beabstandeten Punkten an der ersten Substratträgeroberfläche 21 und der zweiten Substratträgeroberfläche 22 die Geschwindigkeiten der Gasströmung beim Evakuieren der Kammer 30 jeweils im Wesentlichen gleich sind. Darüber hinaus können an zwei voneinander vertikal beabstandeten Punkten an der ersten Substratträgeroberfläche 21 und der zweiten Substratträgeroberfläche 22 die Geschwindigkeiten der Gasströmung beim Fluten der Kammer 30 jeweils im Wesentlichen gleich sein. Ein Strömungswiderstand für die Gasströmung in dem Bereich zwischen der ersten Substratträgeroberfläche 21 und der ersten Innenoberfläche 31 und ein Strömungswiderstand für die Gasströmung in dem Bereich zwischen der zweiten Substratträgeroberfläche 22 und der zweiten Innenoberfläche 32 können im Wesentlichen gleich sein, wenn der Substratträger 20 symmetrisch zwischen der ersten Innenoberfläche 31 und der zweiten Innenoberfläche 32 positioniert ist, um statische Druckunterschiede zwischen der ersten Substratträgeroberfläche 21 und der zweiten Substratträgeroberfläche 22 zu minimieren. Beispielsweise kann ein Verhältnis eines ersten Strömungswiderstands zwischen dem Substratträger 20 und der ersten Innenoberfläche 31 zu einem zweiten Strömungswiderstand zwischen dem Substratträger 20 und der zweiten Innenoberfläche 32 zwischen 0,95 und 1,05 und bevorzugt zwischen 0,97 und 1,03 liegen.

Durch eine Ausgestaltung, bei der das Verhältnis des ersten Abstands $d_1$ zwischen der ersten Innenoberfläche 31 und der ersten Substratträgeroberfläche 21 zu der Länge L des Substratträger und das Verhältnis eines zweitens Abstands $d_2$ zwischen der zweiten Innenoberfläche 32 und der zweiten Substratträgeroberfläche 22 zu einer Länge L des Substratträgers 20 jeweils kleiner als 0,1, bevorzugt kleiner als 0,05 und insbesondere kleiner als 0,025 ist und die Abstände $d_1$ und $d_2$ einander

ähnlich sind, können flache Innenvolumina in der Kammer zwischen dem Substratträger und den Innenwänden der Kammer gebildet werden, die rasch geflutet und/oder evakuiert werden können. Druckdifferenzen zwischen Ober- und Unterseite des Substratträgers können gering gehalten werden.

Wird die Kammer an zwei gegenüberliegenden Seiten geflutet und/oder abgepumpt, kann insbesondere das Verhältnis des ersten Abstands $d_1$ zur Hälfte der Substratträgerlänge kleiner als 0,1, bevorzugt kleiner als 0,05 sein, also $d_1/(L/2) < 0,1$, bevorzugt $d_1/(L/2) < 0,05$, und das Verhältnis des zweiten Abstands $d_2$ zur Hälfte der Substratträgerlänge kann kleiner als 0,1, bevorzugt kleiner als 0,05, also $d_2/(L/2) < 0,1$, bevorzugt $d_2/(L/2) < 0,05$.

Der horizontal auf der Fördereinrichtung 40 aufliegende Substratträger 20 kann eine Größe von mehr als 1 m², insbesondere von mehr als 2 m², beispielsweise von wenigstens 2,25 m² aufweisen. Die erste Substratträgeroberfläche 21 und die zweite Substratträgeroberfläche 22 können jeweils flach ausgebildet sein. Der Substratträger 20 kann zwischen der ersten Innenoberfläche 31 und der zweiten Innenoberfläche 32 der Kammer so positioniert werden, dass eine relative Differenz eines ersten Abstands $d_1$ zwischen der ersten Substratträgeroberfläche 21 und der ersten Innenoberfläche 31 und eines zweiten Abstands $d_2$ zwischen der zweiten Substratträgeroberfläche 22 und der zweiten Innenoberfläche 32 weniger als 15%, bevorzugt weniger als 8%, beträgt, d.h. so, dass $|d_1 - d_2|/\max(d_1, d_2) < 15\%$, und insbesondere so, dass $|d_1 - d_2|/\max(d_1, d_2) < 8\%$. Durch die im Wesentlichen symmetrische Positionierung des Substratträgers 20 in der Kammer 30 ist die beim Fluten oder Evakuieren jeweils entstehende Gasströmung auf der Ober- und Unterseite des Substratträgers 20 gleich, so das Druckdifferenzen zwischen der ersten Substratträgeroberfläche 21 und der zweiten Substratträgeroberfläche 22 vermieden werden.

Die Vakuumschleuse 30 weist eine Strömungskanalanordnung 51, 52, 56, 57 zum Evakuieren und Fluten der Kammer 30 auf. Die Strömungskanalanordnung kann einen ersten Kanal 51 aufweisen, über den die Kammer 30 sowohl geflutet als auch evakuiert werden kann. Der erste Kanal 51 kann an einer Stirnseite der Kammer 30 angeordnet sein, über die der Substratträger 20 in die Kammer 30 eingefahren oder aus der Kammer 30 ausgefahren wird. Der erste Kanal 51 kann sich quer zur Fahrtrichtung des Substratträgers 20 erstrecken. Bei einer anderen Ausgestaltung kann der erste Kanal 51 an einer Längsseite der Kammer 30 angeordnet sein und sich parallel zur Fahrtrichtung des Substratträgers 20 erstrecken.

Gegenüberliegend zu dem ersten Kanal 51 ist ein weiterer erster Kanal 56 angeordnet. Der weitere erste Kanal 56 ermöglicht sowohl ein Fluten als auch ein Evakuieren der Kammer 30 . Im Betrieb wird die Kammer 30 gleichzeitig sowohl über den ersten Kanal 51 als auch über den weiteren ersten Kanal 56 evakuiert.

Im Betrieb wird die Kammer 30 gleichzeitig sowohl über den ersten Kanal 51 als auch über den weiteren ersten Kanal 56 geflutet. Durch das gleichzeitige Fluten oder Evakuieren an gegenüberliegenden Seiten der Kammer 30 wird das über den Substratträgers 20 jeweils strömende maximale Gasvolumen halbiert.

Der ersten Kanal 51 und der weitere erste Kanal 56 sind so angeordnet, dass beim Fluten und/oder Evakuieren der Substratträger 20 und die daran positionierten Substrate in einer Draufsicht nicht mit dem ersten Kanal 51 und dem weiteren ersten Kanal 56 überlappen. Druckdifferenzen zwischen der ersten Substratträgeroberfläche 21 und der zweiten Substratträgeroberfläche 22 können so vermieden werden. Der erste Kanal 51 und der weitere erste Kanal 56 sind vorteilhaft jeweils so bemessen, dass in vertikaler Richtung kein nennenswerter Druckgradient entsteht. Damit wird sichergestellt, dass auf der Ober- und Unterseite des Substratträgers 20 ein identisches Saugvermögen und Flutvermögen erzielt wird.

Zur Verringerung statischer Druckgradienten beim Evakuieren und Fluten der Kammer 30 können komplexere Strömungskanalanordnungen verwendet werden. Unterhalb des ersten Kanals 51 kann ein zweiter Kanal 52 angeordnet sein. Der zweite Kanal 52 kann über eine oder mehrere Überströmöffnungen 54 mit dem ersten Kanal 51 kommunizieren. Die Überströmöffnungen 54 können jeweils als Schlitze ausgebildet sein. Eine Fläche der einen oder mehreren Überströmöffnungen 54 kann in Draufsicht kleiner, insbesondere viel kleiner als eine Fläche des zweiten Kanals 52 in einer horizontalen Schnittebene sein. Die Überströmöffnungen 54 zwischen dem ersten Kanal 51 und dem zweiten Kanal 52 sind so angeordnet und dimensioniert, dass über die Längsrichtung des ersten Kanals 51 ein gleichmäßiges Überströmen des Gases zwischen dem ersten Kanal 51 und dem zweiten Kanal 52 erfolgt. Der erste Kanal 51 kann somit als ein oberer Ausgleichskanal und der zweite Kanal 52 als ein unterer Ausgleichskanal dienen. Der erste Kanal 51 und der zweite Kanal 52 in Kombination können einen Druckausgleich dahingehend bewirken, dass entlang der Längsrichtung des ersten Kanals 51 keine signifikante Änderung des hydrostatischen Drucks beim Evakuieren oder Fluten auftritt und dass entlang der Höhe des ersten Kanals 51 keine signifikante Änderung des hydrostatischen Drucks beim Evakuieren oder Fluten auftritt.

Die Strömungskanalanordnung kann symmetrisch, insbesondere spiegelsymmetrisch zu einer Mittelebene 90 der Kammer 30 ausgestaltet sein. Unterhalb des weiteren ersten Kanals 56 kann ein weiterer zweiter Kanal 57 angeordnet sein. Der weitere zweite Kanal 57 kann über eine oder mehrere weitere Überströmöffnungen mit dem weiteren ersten Kanal 56 kommunizieren. Die weiteren Überströmöffnungen können jeweils als Schlitze in einem Schlitzblech 58a ausgebildet sein. Ein (nicht dargestelltes) weiteres Prallblech zum Umlenken der Gasströmung kann die weiteren Überströmöffnungen wenigstens teilweise überdecken. Die weiteren Überströmöffnungen zwischen dem weiteren ersten Kanal 56 und dem weiteren zweiten Kanal 57 sind so angeordnet und dimensioniert, dass über die Längsrichtung des weiteren ersten Kanals 56 ein gleichmäßiges Überströmen des Gases zwischen dem weiteren ersten Kanal 56 und dem weiteren zweiten Kanal 57 erfolgt. Der weitere erste Kanal 56 kann somit als ein oberer Ausgleichskanal und der weitere zweite Kanal 57 als ein unterer Ausgleichskanal dienen. Der weitere erste Kanal 56 und der weitere zweite Kanal 57 in Kombination können einen Druckausgleich dahingehend bewirken, dass entlang der Längsrichtung des weiteren ersten Kanals 56 keine signifikanten Änderungen des hydrostatischen Drucks beim Evakuieren oder Fluten auftreten, und dass entlang der Höhe des weiteren ersten Kanals 56 keine signifikanten Änderungen des hydrostatischen Drucks beim Evakuieren oder Fluten auftreten.

Wie in Figur 4 dargestellt, können zur Vergleichmäßigung der Gasströmung zwischen dem ersten Kanal 51 und dem zweiten Kanal 52 weitere Elemente vorgesehen sein. Die Überströmöffnungen 54 können in einem Schlitzblech 53a vorgesehen sein. Ein Prallblech 53b zum Umlenken der Gasströmung kann die Überströmöffnungen 54 wenigstens teilweise überdecken. Das Prallblech 53b kann integral mit dem Schlitzblech 53a ausgebildet sein oder kann als ein davon verschiedenes separates Teil vorgesehen sein. Das Prallblech 53b kann nicht-geschlitzt sein.

Öffnungen zur Verbindung mit einer Evakuierungseinrichtung zum Evakuieren der Kammer 30 oder mit einer Fluteinrichtung zum Fluten der Kammer 30 können an dem zweiten Kanal 52 und dem weiteren zweiten Kanal 57 vorgesehen sein. Diese Öffnungen können zum Innern der Kammer 30 hin mit dem Schlitzblech 53a und/oder dem nichtgeschlitzten Prallblech 53b abgedeckt sein, so dass das einströmende Gas über die Überströmöffnungen 54 und nach Umlenkung am Prallblech 53b in die Kammer 30 eintritt und so insgesamt abgebremst wird. Das Abbremsen des Gases beim Fluten kann durch die Verwendung der Überströmöffnung 54 und/oder durch das Prallblech 53b erfolgen. Die Evakuierungseinrichtung kann eine Pumpe aufweisen. Die Fluteinrichtung kann eine Einströmöffnung für Gas aufweisen.

Die Kammer 30 und die Strömungskanalanordnung mit den Kanälen 51, 52, 56, 57 ist so ausgestaltet, dass die in der Kammer 30 auftretenden Gasströmungen niemals senkrecht zu den auf dem Substratträger 20 positionierten Substraten gerichtet sind.

Die Vakuumschleuse 10 kann konfiguriert sein, um die Kammer 30 zweistufig abzupumpen. Dazu kann die Vakuumschleuse 10 ein erstes Pumpventil 71 und ein zweites Pumpventil 72 aufweisen. Das erste Pumpventil 71 und das zweite Pumpventil 72 können unterschiedlich dimensioniert sein und können von einer (nicht dargestellten) Steuerung so angesteuert werden, dass beim Evakuieren sequentiell das erste Pumpventil 71 und das zweite Pumpventil 72 geöffnet werden, um unterschiedliche Druckveränderungsraten in der Kammer 30 zu erzeugen. Das erste Pumpventil 71 und das zweite Pumpventil 72 können beide mit dem zweiten Kanal 52 kommunizieren. Das erste Pumpventil 71 kann mit einem ersten Pumpstutzen 61 kommunizieren, der benachbart dem zweiten Kanal 52 an der Kammer 30 angeordnet ist. Das zweite Pumpventil 72 kann mit einem zweiten Pumpstutzen 62 kommunizieren, der benachbart dem zweiten Kanal 52 an der Kammer 30 angeordnet ist.

Wenn die Kammer 30 über zwei gegenüberliegende Seiten abgepumpt wird, kann eine entsprechende Anordnung mit einem weiteren ersten Pumpventil 76, einem weiteren ersten Pumpstutzen 66, einem weiteren zweiten Pumpventil 77 und einem weiteren zweiten Pumpstutzen 67 an der gegenüberliegenden Seite der Kammer 30 vorgesehen sein. Die Steuerung kann die Pumpventile 71, 72 und die weiteren Pumpventile 76, 77 so ansteuern, dass beim Evakuieren während eines ersten Zeitintervalls gleichzeitig das zweite Pumpventil 72 und das weitere zweite Pumpventil 77 geöffnet sind, während das erste Pumpventil 71 und das weitere erste Pumpventil 76 geschlossen sind. Die zweiten Ventile 72, 77 können kleiner dimensioniert sein als die ersten Ventile 71,76, so dass ein sanfteres Anpumpen realisiert werden kann. Die Steuerung kann die Pumpventile 71, 72, 76, 77 so ansteuern, dass beim Evakuieren während eines zweiten Zeitintervalls gleichzeitig das erste Pumpventil 71 und das weitere erste Pumpventil 76 geöffnet sind, während das zweite Pumpventil 72 und das weitere zweite Pumpventil 77 ebenfalls geöffnet oder geschlossen sind.

Das erste Pumpventil 71 und das weitere erste Pumpventil 76 können eine identische Ausgestaltung aufweisen. Das zweite Pumpventil 72 und das weitere zweite Pumpventil 77 können eine identische Ausgestaltung aufweisen. Bevorzugt wird nur eine Pumpeinrichtung verwendet, von der die Schleuse über gegenüberliegende Seiten der Kammer 30 evakuiert wird. Die Verbindungen zwischen der Pumpeinrichtung und den ersten Pumpventilen 71, 76 und den zweiten Pumpventilen 72, 77 können symmetrisch sein, um eine gleich Pumpleistung auf beiden Seiten der Kammer 30 zu bewerkstelligen. Die Seiten können dabei die Stirnseiten oder Längsseiten der Kammer 30 sein.

Die Pumpventile können über Pumpleitungen 63a, 63b, 68a, 68b und eine Verzweigung mit wenigstens einer Pumpe verbunden sein. Die Pumpe, das erste Pumpventil 71 und das weitere erste Pumpventil 76 können konfiguriert sein, während des zweiten Zeitintervalls beim Evakuieren den Druck im Inneren der Kammer mit einer Rate von wenigstens100 hPA/s, bevorzugt wenigstens 300 hPa/s, weiter bevorzugt von 300 hPa/s bis 500 hPa/s zu verringern.

Die Vakuumschleuse 10 kann konfiguriert sein, um die Kammer 30 zweistufig zu fluten. Dazu kann die Vakuumschleuse 10 ein erstes Flutventil 73 und ein zweites Flutventil 74 aufweisen. Das erste Flutventil 73 und das zweite Flutventil 74 können unterschiedlich dimensioniert sein und können von der Steuerung so angesteuert werden, dass beim Fluten sequentiell das erste Flutventil 73 und das zweite Flutventil 74 geöffnet werden, um unterschiedliche zeitliche Druckänderungen in der Kammer 30 zu erzeugen. Das erste Flutventil 73 und das zweite Flutventil 74 können beide über eine Flutleitung 64 mit dem zweiten Kanal 52 kommunizieren. Das erste Flutventil 73 und das zweite Flutventil 74 können beide über eine weitere Flutleitung 69 mit dem weiteren zweiten Kanal 57 kommunizieren. Die Steuerung kann die Flutventile 73, 74 so ansteuern, dass beim Fluten während eines ersten Zeitintervalls das erste Flutventil 73 geöffnet ist, während das zweite Flutventil 74 geschlossen ist. Die Steuerung kann die Flutventile 73, 74 so ansteuern, dass beim Fluten während eines zweiten Zeitintervalls das zweite Flutventil 74 geöffnet ist, während das erste Flutventil 73 geschlossen ist. In einer alternativen Ausführung können, beim Fluten während eines zweiten Zeitintervalls, das erste Flutventil 73 und das zweite Flutventil beide geöffnet werden.

Bevorzugt wird nur eine Fluteinrichtung verwendet, um die Kammer 30 über zwei Seiten zu fluten. Die Verbindung zwischen dem ersten Flutventil 73 und dem zweiten Kanal 52 und die Verbindung zwischen dem ersten Flutventil 73 und dem weiteren zweiten Kanal 57 können symmetrisch sein, um die Kammer 30 von beiden Seiten der Kammer 30 mit dem gleichen Volumenstrom zu fluten. Die Verbindung zwischen dem zweiten Flutventil 74 und dem zweiten Kanal 52 und die Verbindung zwischen dem zweiten Flutventil 74 und dem weiteren zweiten Kanal 57 können symmetrisch sein, um die Kammer 30 von beiden Seiten der Kammer 30 mit dem gleichen Volumenstrom zu fluten. Die Seiten können dabei die Stirnseiten oder Längsseiten der Kammer 30 sein.

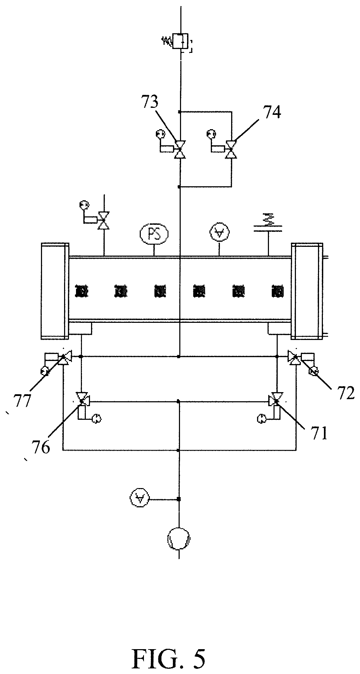

Figur 5 zeigt einen pneumatischen Schaltplan der Vakuumschleuse 30. Unterschiedlich dimensionierte erste Pumpventile 71, 76 und zweite Pumpventile 72, 77 sowie unterschiedlich dimensionierte erste und zweite Flutventile 73, 74 ermöglichen ein zweistufiges Abpumpen und ein zweistufiges Fluten der Kammer. Dabei kann Gas beim Fluten symmetrisch an den gegenüberliegenden Seiten der Kammer einströmen und beim Evakuieren symmetrisch an den gegenüberliegenden Seiten der Kammer abgesaugt werden.

Das System kann im Hinblick auf seine fluiddynamischen Eigenschaften symmetrisch ausgestaltet sein. Dazu können die Verbindungsleitungen zwischen dem ersten Flutventil 73 und den gegenüberliegenden Seiten der Kammer 30 identische Längen und identische Durchmesser aufweisen und symmetrisch angeordnet sein. Die Verbindungsleitungen zwischen dem zweiten Flutventil 74 und den gegenüberliegenden Seiten der Kammer 30 können identische Längen und identisch Durchmesser aufweisen und können symmetrisch angeordnet sein.

Alternativ oder zusätzlich können die Verbindungsleitungen zwischen der Pumpe und den Pumpventilen 71, 72 identische Längen und identische Durchmesser aufweisen wie die Verbindungsleitungen zwischen der Pumpe und den weiteren Pumpventilen 76, 77. Die Verbindungsleitungen zwischen den Pumpventilen 71, 72 und einer ersten Seite der Schleusenkammer können identische Längen und identische Durchmesser aufweisen wie die Verbindungsleitungen zwischen den Pumpventilen 76, 77 und einer der ersten Seite gegenüberliegenden zweiten Seite der Kammer 30.

Bei den Seiten der Kammer 30 kann es sich dabei jeweils um die Längsseiten oder die Stirnseiten der Kammer 30 handeln.

Figur 6 und Figur 7 veranschaulichen die Funktionsweise der erfindungsgemäßen Vakuumschleuse 30. Figur 6 zeigt ein Geschwindigkeitsfeld 81, 82 einer Gasströmung an der ersten Substratträgeroberfläche 21 beim Evakuieren der Kammer 30. Figur 7 zeigt ein Geschwindigkeitsfeld 83, 84 der Gasströmung an der zweiten Substratträgeroberfläche 22 beim Evakuieren der Kammer 30. Da Gas an entgegengesetzten Seiten über den ersten Kanal 51 und den weiteren ersten Kanal 56 abgesaugt wird, wird ein zur Mittelebene 90 der Kammer 30 im Wesentlichen spiegelsymmetrisches Geschwindigkeitsfeld erzeugt. Für jeden Punkt auf der ersten Substratträgeroberfläche 21 ist die Geschwindigkeit 81, 82 der Gasströmung dabei in Betrag und Richtung gleich der Geschwindigkeit 83, 84 der Gasströmung an dem entsprechenden, gegenüberliegenden Punkt der zweiten Substratträgeroberfläche 22. Statische Druckunterschiede werden reduziert oder weitgehend eliminiert.

Die Ausgestaltung der Strömungskanalanordnung führt zu einem Geschwindigkeitsfeld, das entlang einer Längsrichtung 50 des ersten Kanals 51 homogen ist, so dass keine Druckgradienten parallel zur Längsrichtung 50 des ersten Kanals 51 an der ersten Substratträgeroberfläche 21 und der zweiten Substratträgeroberfläche 22 bestehen. Unerwünschte Querströmungen, die zu einer Verschiebung der Substrate an oder in dem Substratträger 20 führen können, können so vermieden werden.

Durch die erfindungsgemäße Vakuumschleuse wird das Risiko einer unerwünschten Verschiebung von Substraten relativ zum Substratträger 20 und einer Beschädigung der Substrate verringert. Beispielsweise kann ein mit 64 Substraten belegter Substratträger 20 in die Schleuse eingefahren werden, die danach rasch abgepumpt oder geflutet werden kann. Die Größe des Substratträgers 20 kann mehr als 2 m$^2$ betragen. Substrate, die Si-Wafer sein können, können eine Dicke größer als 100 $\mu$m, bevorzugt zwischen 120 und 500 $\mu$m aufweisen. Bei einer Dicke von 120 $\mu$m entspricht dies einem Gewicht von ca. 10 g pro Wafer. Bei einer Waferfläche von 15,6 $\times$ 15,6 cm$^2$ = 243 cm$^2$ beträgt die Flächenmasse 10 g / 243 cm$^2$ = 0,041 g/cm$^2$. Somit reicht ein Überdruck von 4,1 Pa an der Unterseite des Wafers, um diesen Wafer bei einer Lagerung senkrecht zum Erdschwerefeld im Substratträger 20 anzuheben. Weiterhin darf an der ersten Substratträgeroberfläche 21 kein Überdruck entstehen, da ansonsten durch die entstehende Druckdifferenz zwischen Ober- und Unterseite der Wafer durch die Druckkraft zerstört werden könnte. Um dieses zu verhindern, wird durch die erfindungsgemäße Vakuumschleuse sichergestellt, dass die Druckdifferenz zwischen der ersten und zweiten Substratträgeroberfläche 21, 22 kleiner als 10 Pa, bevorzugt kleiner als 5 Pa, weiter bevorzugt kleiner als 4 Pa bleibt. Experimente bestätigen, dass bei einer Vakuumschleuse mit einem Volumen von 350 l Flutzeiten von 5 s erreichbar sind. Dabei wurde in der Anfangsphase des Flutens ein Druckgradient von 350 hPa/s erreicht, was einem Volumenstrom von 120 l/s entspricht. Bei Annäherung des Druckes an den äußeren Atmosphärendruck kann der Gradient auf 100 hPa/s abflachen. Unter diesen Umständen, bei denen eine hohe zeitliche Druckänderungsrate auftritt, trat in der erfindungsgemäßen Vakuumschleuse 10 keine Bewegung der in den Substratträger 20 eingelegten Wafer auf.

Während Ausführungsbeispiele unter Bezugnahme auf die Figuren beschrieben wurden, können zusätzliche und alternative Merkmale bei weiteren Ausführungsbeispielen eingesetzt werden. Beispielsweise ist es nicht unbedingt erforderlich, dass die Kammer gleichzeitig über zwei entgegengesetzte Seiten geflutet wird und/oder dass die Kammer gleichzeitig über zwei entgegengesetzte Seiten evakuiert wird. Der weitere erste Kanal 56 und der weitere zweite Kanal 57 können bei weiteren Ausführungsbeispielen auch weggelassen werden.

Ausführungsbeispiele der Erfindung können vorteilhaft zur Beschichtung von Wafern eingesetzt werden. Die erfindungsgemäße Vakuumschleuse kann beispielsweise bei einer PVD, CVD- oder MOCVD-Beschichtungsanlage für rechteckige oder runde Wafer verwendet werden, ohne darauf beschränkt zu sein.

**Patentansprüche**

1. Vakuumschleuse (10) für eine Vakuumbeschichtungsanlage, mit

    einer Kammer (30) zur Aufnahme eines Substratträgers (20) mit einem Kammeroberteil (38) und einem Kammerunterteil (39), wobei die Kammer (30) eine erste und eine zweite im Wesentlichen ebene Innenoberfläche (31, 32) aufweist und der Substratträger (20) eine Länge L aufweist,
    einer Fördereinrichtung (40) mit Antriebskomponenten (41) zum Fördern des Substratträgers (20), und
    einer Strömungskanalanordnung (51, 52, 56, 57) zum Evakuieren und Fluten der Kammer (30), die konfiguriert ist, eine Gasströmung (81, 82, 83, 84) sowohl in einem ersten Bereich zwischen der ersten Innenoberfläche (31) und einer der ersten Innenoberfläche (31) gegenüberliegenden ersten Substratträgeroberfläche (21) als auch in einem zweiten Bereich zwischen der zweiten Innenoberfläche (32) und einer der zweiten Innenoberfläche (32) gegenüberliegenden zweiten Substratträgeroberfläche (22) hervorzurufen,
    **dadurch gekennzeichnet, dass** die Strömungskanalanordnung (51, 52, 56, 57) gegenüberliegende Kanäle (51, 56) aufweist, über die die Kammer (30) sowohl geflutet als auch evakuiert werden kann, wobei ein Fluten über die gegenüberliegenden Kanäle (51, 56) gleichzeitig möglich ist und wobei ein Evakuieren über die gegenüberliegenden Kanäle (51, 56) gleichzeitig möglich ist, wobei die gegenüberliegenden Kanäle (51, 56) jeweils wenigstens einen ersten Kanal (51, 56) und einen zweiten Kanal (52, 57) aufweisen, die durch wenigstens eine Überströmöffnung (54) in einer Fluidverbindung stehen;
    wobei ein Verhältnis des ersten Abstands $(d_1)$ zwischen der ersten Innenoberfläche (31) und der ersten Substratträgeroberfläche (21) zu der Länge (L) des Substratträgers (20) kleiner als 0,1, bevorzugt kleiner als 0,05, weiter bevorzugt kleiner als 0,025 ist, und wobei das Verhältnis des zweiten Abstands $(d_2)$ zwischen der zweiten Innenoberfläche (32) und der zweiten Substratträgeroberfläche (22) zu der Länge (L) des Substratträgers (20) kleiner als 0,1 ist.

2. Vakuumschleuse nach Anspruch 1, wobei das Verhältnis des zweiten Abstands $(d_2)$ zwischen der zweiten Innenoberfläche (32) und der zweiten Substratträgeroberfläche (22) zu der Länge (L) des Substratträgers (20) kleiner als 0,05 ist.

3. Vakuumschleuse nach Anspruch 1, wobei das Verhältnis des zweiten Abstands $(d_2)$ zwischen der zweiten Innenoberfläche (32) und der zweiten Substratträgeroberfläche (22) zu der Länge (L) des Substratträgers (20) kleiner als 0,025 ist.

4. Vakuumschleuse nach einem der vorhergehenden Ansprüche,
    wobei die Fördereinrichtung (40) konfiguriert ist, den Substratträger (20) zwischen der ersten Innenoberfläche (31) und der zweiten Innenoberfläche (32) derart zu positionieren, dass

$$|d_1 - d_2|/\max(d_1, d_2) < 15\,\%.$$

5. Vakuumschleuse nach Anspruch 4,

wobei $d_1$ - $d_2$|/max($d_1$, $d_2$) < 8 %.

6. Vakuumschleuse nach einem der vorhergehenden Ansprüche,
   wobei sich die gegenüberliegenden Kanäle (51, 56) parallel zueinander erstrecken.

7. Vakuumschleuse nach Anspruch 6,

   wobei die gegenüberliegenden Kanäle (51, 56) entlang einer Fahrtrichtung (43) der Fördereinrichtung (40) um mindestens die Länge des Substratträgers voneinander beabstandet sind und/oder
   wobei die gegenüberliegenden Kanäle (51, 56) an entgegengesetzten Seiten der Kammer (30) angeordnet sind und/oder
   wobei die gegenüberliegenden Kanäle (51, 56) in Bezug auf eine Mittelebene (90) der Kammer (30) spiegelsymmetrisch zueinander angeordnet sind.

8. Vakuumschleuse nach Anspruch 1, mit
   einer Einrichtung (53a) zur Vergleichmäßigung der Strömung zwischen dem ersten Kanal (51) und dem zweiten Kanal (52), die die wenigstens eine Überströmöffnung (54) aufweist, wobei optional die Überstromöffnung (54) kleiner als ein Querschnitt des zweiten Kanales (52) ist.

9. Vakuumschleuse nach Anspruch einem der vorhergehenden Ansprüche, ferner mit wenigstens einem Anschlussstutzen (61, 62, 66, 67) zur Verbindung mit einer Evakuierungseinrichtung und/oder einer Fluteinrichtung und mit wenigstens einer Ventilanordnung (71, 72, 73, 74, 76, 77), die zwischen der Kammer (30) und der Evakuierungseinrichtung und/oder Fluteinrichtung vorgesehen ist, wobei die Ventilanordnung ein erstes Ventil (71, 73, 76) und ein zweites Ventil (72, 74, 77), die unterschiedlich dimensioniert sind, aufweist, ferner mit einer Steuerung zum Ansteuern des ersten Ventils (71, 73, 76) und des zweiten Ventils (72, 74, 77) für ein zweistufiges Fluten oder ein zweistufiges Evakuieren der Kammer (30).

10. Vakuumschleuse nach Anspruch 9, ferner mit zueinander symmetrisch ausgestalteten Fluidverbindungsleitungen zwischen der Evakuierungseinrichtung und entgegengesetzten Seiten der Kammer (30) und/oder zueinander symmetrisch ausgestalteten Fluidverbindungsleitungen zwischen der Fluteinrichtung und entgegengesetzten Seiten der Kammer (30).

11. Verfahren zum Einschleusen eines Substratträgers (20) in eine Vakuumbeschichtungsanlage und zum Ausschleusen des Substratträgers (20) aus der Vakuumbeschichtungsanlage, mit den Schritten:

    Positionieren des Substratträgers (20) mit einer Mehrzahl von Substraten in einer Kammer (30) einer Vakuumschleuse,
    Evakuieren der Kammer (30), und
    Fluten der Kammer (30);
    wobei der Substratträger eine Länge L aufweist;
    wobei das Evakuieren und Fluten der Kammer (30) über dieselben gegenüberliegenden Kanäle (51, 52, 56, 57) erfolgt, wobei die Kammer (30) gleichzeitig über wenigstens zwei an entgegengesetzten Seiten der Kammer (30) angeordnete Kanäle (51, 52, 56, 57) evakuiert wird, wobei die Kammer (30) gleichzeitig über die wenigstens zwei an den entgegengesetzten Seiten der Kammer (30) angeordnete Kanäle (51, 52, 56, 57) geflutet wird, wobei die gegenüberliegenden Kanäle (51, 56) jeweils wenigstens einen ersten Kanal (51, 56) und einen zweiten Kanal (52, 57) aufweisen, die durch wenigstens eine Überströmöffnung (54) in einer Fluidverbindung stehen, und wobei das Evakuieren und Fluten der Kammer (30) aufweist:
    Erzeugen einer Gasströmung (81, 82, 83, 84) an einer ersten Substratträgeroberfläche (21) und einer dazu entgegengesetzten zweiten Substratträgeroberfläche (22);
    wobei ein Verhältnis des ersten Abstands ($d_1$) zwischen der ersten im Wesentlichen ebenen Innenoberfläche (31) und der ersten Substratträgeroberfläche (21) zu der Länge (L) des Substratträgers (20) kleiner als 0,1 ist, und
    wobei das Verhältnis des zweiten Abstands ($d_2$) zwischen der zweiten im Wesentlichen ebenen Innenoberfläche (32) und der zweiten Substratträgeroberfläche (22) zu der Länge (L) des Substratträgers (20) kleiner als 0,1 ist.

12. Verfahren nach Anspruch 11,
    wobei der Substratträger (20) zwischen der ersten Innenoberfläche (31) und der zweiten Innenoberfläche (32) der Kammer (30) so positioniert wird, dass
    |$d_1$ - $d_2$|/max($d_1$, $d_2$) < 15 %, bevorzugt |$d_1$ - $d_2$|/max($d_1$, $d_2$) < 8 %.

**Claims**

1. A vacuum lock (10) for a vacuum coating plant, comprising

   a chamber (30) for receiving a substrate carrier (20) and having an upper chamber part (38) and a lower chamber part (39), wherein the chamber (30) comprises a first and a second inner surface (31, 32) which is substantially plane and the substrate carrier (20) comprises a length L,
a conveyor (40) with drive components (41) for conveying the substrate carrier (20), and
a flow channel assembly (51, 52, 56, 57) for evacuating and venting the chamber (30), said flow channel assembly being configured to cause a gas flow (81, 82, 83, 84) in both a first region between the first inner surface (31) and a first substrate carrier surface (21) facing the first inner surface (31) and in a second region between the second inner surface (32) and a second substrate carrier surface (22) facing the second inner surface (32),
**characterized in that**
the flow channel assembly (51, 52, 56, 57) comprises opposing channels (51, 56) through which the chamber (30) can be vented and evacuated, wherein a venting through the opposing channels (51, 56) is simultaneously possible and wherein evacuating through the opposing channels (51, 56) is simultaneously possible, wherein the opposing channels (51, 56) each comprise at least a first channel (51, 56) and a second channel (52, 57) which are in a fluid connection through at least one overflow orifice (54);
wherein a ratio of the first distance ($d_1$) between the first inner surface (31) and the first substrate carrier surface (21) to the length (L) of the substrate carrier (20) is smaller than 0.1, preferably smaller than 0.05, further preferably smaller than 0.025, and
wherein the ratio of the second distance ($d_2$) between the second inner surface (32) and the second substrate carrier surface (22) to the length (L) of the substrate carrier (20) is smaller than 0.1.

2. The vacuum lock according to claim 1, wherein the ratio of the second distance (d2) between the second inner surface (32) and the second substrate carrier surface (22) to the length (L) of the substrate carrier (20) is smaller than 0.05.

3. The vacuum lock according to claim 1, wherein the ratio of the second distance (d2) between the second inner surface (32) and the second substrate carrier surface (22) to the length (L) of the substrate carrier (20) is smaller than 0.025.

4. The vacuum lock according to any one of the preceding claims, wherein the conveyor (40) is configured to position the substrate carrier (20) between the first inner surface (31) and the second inner surface (32) such that

$$|d_1 - d_2|/max(d_1, d_2) < 15\%.$$

5. The vacuum lock according to claim 4, wherein

$$|d_1 - d_2|/max(d_1, d_2) < 8\%.$$

6. The vacuum lock according to any one of the preceding claims, wherein the opposing channels (51, 56) extend parallel to each other.

7. The vacuum lock according to claim 6, wherein the opposing channels (51, 56) are spaced apart by at least the length of the substrate carrier along a travel direction (43) of the conveyor (40) and/or

   wherein the opposing channels (51, 56) are arranged on opposing sides of the chamber (30) and/or
   wherein the opposing channels (51, 56) are arranged mirror-symmetrically to each other with respect to a center plane (90) of the chamber (30).

8. The vacuum lock according to claim 1, comprising a device (53a) for homogenization of the flow between the first channel (51) and the second channel (52), said device comprising the at least one overflow orifice (54), wherein optionally the overflow orifice (54) is smaller than a cross section of the second channel (52).

9. The vacuum lock according to any one of the preceding claims, further comprising a at least one connecting branch (61, 62, 66, 67) for connection with an evacuating device and/or a venting device and with at least one valve assembly (71, 72, 73, 74, 76, 77) which is provided between the chamber (30) and the evacuating device and/or the venting device, wherein the valve assembly comprises a first valve (71, 73, 76) and a second valve (72, 74, 77) which are dimensioned differently from each other, further a control for controlling the first valve (71, 73, 76) and the second valve (72, 74, 77) for a two-stage venting or a two-stage evacuation of the chamber (30).

10. The vacuum lock according to claim 9, further comprising lines for fluid communication configured symmetrically to each other between the evacuating device and opposing sides of the chamber (30), and/or lines for fluid communication configured symmetrically to each other between the venting device and opposing sides of the chamber (30).

11. A method for introducing a substrate carrier (20) into a vacuum coating plant and for removing the substrate carrier (20) from the vacuum coating plant, comprising the steps of:

    positioning the substrate carrier (20) with a plurality of substrates within a chamber (30) of a vacuum lock,

evacuating the chamber (30), and

venting the chamber (30);

wherein the substrate carrier comprises a length L;

wherein evacuating and venting the chamber (30) is carried out via the same opposing channels (51, 52, 56, 57), wherein the chamber (30) is evacuated simultaneously via at least two channels (51, 52, 56, 57) arranged at opposing sides of the chamber (30), wherein the chamber (30) is vented simultaneously via at least two channels (51, 52, 56, 57) arranged at opposing sides of the chamber (30), wherein the opposing channels (51, 56) each comprise at least a first channel (51, 56) and a second channel (52, 57) which are in fluid connection via at least one overflow orifice (54) and wherein evacuating and venting the chamber (30) comprises:

generating a gas flow (81, 82, 83, 84) on a first substrate carrier surface (21) and a second substrate carrier surface (22) opposite thereto,

wherein a ratio of the first distance ($d_1$) between the first inner surface (31) which is substantially plane and the first substrate carrier surface (21) to the length (L) of the substrate carrier (20) is smaller than 0.1, and

wherein the ratio of the second distance ($d_2$) between the second inner surface (32) which is substantially plane and the second substrate carrier surface (22) to the length (L) of the substrate carrier (20) is smaller than 0.1.

12. The method according to claim 11,
wherein the substrate carrier (20) is positioned between the first inner surface (31) and the second inner surface (32) of the chamber (30) such that $|d_1 - d_2|/\max(d_1, d_2) < 15\%$, preferably $|d_1 - d_2|/\max(d_1, d_2) < 8\%$.

## Revendications

1. Sas à vide (10) pour une installation de revêtement sous vide, avec

une chambre (30) destinée à recevoir un support de substrat (20) avec une partie supérieure de chambre (38) et une partie inférieure de chambre (39), la chambre (30) présentant une première et une deuxième surfaces intérieures (31, 32) essentiellement planes et le support de substrat (20) présentant une longueur L,

un dispositif de convoyage (40) avec des composants d'entraînement (41) pour transporter le support de substrat (20), et

un agencement de canaux d'écoulement (51, 52, 56, 57) pour évacuer et remplir la chambre (30), qui est configuré de manière à créer un écoulement de gaz (81, 82, 83, 84) à la fois dans une première zone entre la première surface intérieure (31) et une première surface de support de substrat (21) opposée à la première surface intérieure (31), et dans une deuxième zone entre la deuxième surface intérieure (32) et une deuxième surface de support de substrat (22) opposée à la deuxième surface intérieure (32), **caractérisé en ce que**

l'agencement de canaux d'écoulement (51, 52, 56, 57) présente des canaux opposés (51, 56) par lesquels la chambre (30) peut être à la fois remplie et evacuée, un remplissage étant possible simultanément par les canaux opposés (51, 56) et une évacuation étant possible simultanément par les canaux opposés (51, 56), les canaux opposés (51, 56) présentant chacun au moins un premier canal (51, 56) et un deuxième canal (52, 57) qui sont en communication fluidique par au moins une ouverture de passage (54) ; le rapport entre la première distance ($d_1$) entre la première surface intérieure (31) et la première surface de support de substrat (21) et la longueur (L) du support de substrat (20) étant inférieur à 0,1, de préférence inférieur à 0,05, et de préférence encore inférieur à 0,025, et le rapport entre la deuxième distance ($d_2$) entre la deuxième surface intérieure (32) et la deuxième surface de support de substrat (22) et la longueur (L) du support de substrat (20) étant inférieur à 0,1.

2. Sas à vide selon la revendication 1, dans lequel le rapport entre la deuxième distance ($d_2$) entre la deuxième surface intérieure (32) et la deuxième surface de support de substrat (22) et la longueur (L) du support de substrat (20) est inférieur à 0,05.

3. Sas à vide selon la revendication 1, dans lequel le rapport entre la deuxième distance ($d_2$) entre la deuxième surface intérieure (32) et la deuxième surface de support de substrat (22) et la longueur (L) du support de substrat (20) est inférieur à 0,025.

4. Sas à vide selon l'une des revendications précédentes,

le dispositif de convoyage (40) étant configuré pour positionner le support de substrat (20) entre la première surface intérieure (31) et la deuxième surface intérieure (32) de telle sorte que

$$|d_1 - d_2|/max(d_1, d_2) < 15\ \%.$$

5. Sas à vide selon la revendication 4, dans lequel

$$|d_1 - d_2|/max(d_1, d_2) < 8\ \%.$$

6. Sas à vide selon l'une des revendications précédentes,
   dans lequel les canaux opposés (51, 56) s'étendent parallèlement les uns par rapport aux autres.

7. Sas à vide selon la revendication 6,

   dans lequel les canaux opposés (51, 56) sont espacés les uns des autres le long d'une direction de déplacement (43) du dispositif de convoyage (40) d'au moins la longueur du support de substrat et/ou
   dans lequel les canaux opposés (51, 56) sont agencés sur les côtés opposés de la chambre (30) et/ou
   dans lequel les canaux opposés (51, 56) sont agencés de manière symétrique l'un par rapport à l'autre par rapport à un plan médian (90) de la chambre (30).

8. Sas à vide selon la revendication 1, comprenant

   un dispositif (53a) pour uniformiser le flux entre le premier canal (51) et le deuxième canal (52), qui présente l'au moins une ouverture de passage (54),
   l'ouverture de passage (54) étant éventuellement plus petite qu'une section transversale du deuxième canal (52).

9. Sas à vide selon l'une des revendications précédentes, comprenant en outre

   au moins un raccord (61, 62, 66, 67) pour le raccordement à un dispositif d'évacuation et/ou à un dispositif de remplissage et au moins un dispositif de soupape (71, 72, 73, 74, 76, 77) qui est prévu entre la chambre (30) et le dispositif d'évacuation et/ou le dispositif de remplissage, le dispositif de soupape présentant une première soupape (71, 73, 76) et une deuxième soupape (72, 74, 77) qui sont de dimensions différentes, ainsi qu'une commande pour commander la première soupape (71, 73, 76) et la deuxième soupape (72, 74, 77) pour une inondation en deux étapes ou une évacuation en deux étapes de la chambre (30).

10. Sas à vide selon la revendication 9, comprenant en outre

des conduites de liaison fluidique conçues de manière symétrique entre le dispositif d'évacuation et les côtés opposés de la chambre (30) et/ou des conduites de liaison fluidique conçues de manière symétrique entre le dispositif de remplissage et les côtés opposés de la chambre (30).

11. Procédé pour introduire un support de substrat (20) dans une installation de revêtement sous vide et pour évacuer le support de substrat (20) de l'installation de revêtement sous vide, comprenant les étapes suivantes :

   positionnement du support de substrat (20) avec une pluralité de substrats dans une chambre (30) d'un sas à vide,
   évacuation de la chambre (30), et
   remplissage de la chambre (30), le support de substrat ayant une longueur L ;
   l'évacuation et le remplissage de la chambre (30) s'effectuant par les mêmes canaux opposés (51, 52, 56, 57), la chambre (30) étant évacuée simultanément par au moins deux canaux (51, 52, 56, 57) agencés sur les côtés opposés de la chambre (30), la chambre (30) étant simultanément remplie par au moins deux canaux (51, 52, 56, 57) agencés sur les côtés opposés de la chambre (30),
   les canaux opposés (51, 56) présentant chacun au moins un premier canal (51, 56) et un deuxième canal (52, 57), qui sont en communication fluidique par au moins une ouverture de passage (54), et l'évacuation et le remplissage de la chambre (30) présentant :
   la génération d'un écoulement de gaz (81, 82, 83, 84) au niveau d'une première surface de support de substrat (21) et d'une deuxième surface de support de substrat (22) opposée à celle-ci ; le rapport entre la première distance $(d_1)$ entre la première surface intérieure essentiellement plane (31) et la première surface de support de substrat (21) et la longueur (L) du support de substrat (20) étant inférieur à 0,1, et le rapport entre la deuxième distance $(d_2)$ entre la deuxième surface intérieure essentiellement plane (32) et la deuxième surface de support de substrat (22) et la longueur (L) du support de substrat (20) étant inférieur à 0,1.

12. Procédé selon la revendication 11, dans lequel le support de substrat (20) est positionné entre la première surface intérieure (31) et la deuxième surface intérieure (32) de la chambre (30) de telle sorte que $|d_1 - d_2|/max(d_1, d_2) < 15\ \%$, de préférence $|d_1 - d_2|/max(d_1, d_2) < 8\ \%$.

FIG. 1

FIG. 2

FIG. 3

FIG. 4

FIG. 5

FIG. 6

FIG. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016173125 A1
- DE 102012109830 A1
- DE 102011011279 A1
- DE 102005024181 A1
- DE 102015117753 A1